# EUROPÄISCHE PATENTSCHRIFT

(11) **EP 3 475 713 B1**
(45) Veröffentlichungstag und Bekanntmachung des Hinweises auf die Patenterteilung: **12.10.2022**
(21) Anmeldenummer: 17755146.2
(22) Anmeldetag: 16.08.2017
(51) Int. Cl.: G01R 31/36, G01R 31/3835, G01R 31/392

(54) **VERFAHREN ZUR BESTIMMUNG DES ALTERS EINES ELEKTROCHEMISCHEN ENERGIESPEICHERS**
METHOD FOR DETERMINING THE AGE OF AN ELECTROCHEMICAL ENERGY STORAGE UNIT
PROCÉDÉ DE DÉTERMINATION DE L'ÂGE D'UN ACCUMULATEUR D'ÉNERGIE ÉLECTROCHIMIQUE

(30) Priorität: 25.08.2016 DE 102016215991
(43) Veröffentlichungstag der Anmeldung: 01.05.2019
(73) Patentinhaber: Rolls-Royce Deutschland Ltd & Co KG, 15827 Blankenfelde-Mahlow (DE)
(72) Erfinder: BETZIN, Christopher, 91301 Forchheim (DE); WOLFSCHMIDT, Holger, 91058 Erlangen (DE)
(86) Internationale Anmeldenummer: PCT/EP2017/070709
(87) Internationale Veröffentlichungsnummer: WO 2018/036873

(56) Entgegenhaltungen:
- DE-A1-102010 050 980
- DE-A1-102011 005 769
- DE-A1-102013 213 253
- DE-A1-102013 217 752
- Anonymous: "Vergleich zweier Kurven - Mein MATLAB Forum - goMatlab.de", , 14. Juni 2012 (2012-06-14), Seiten 1-4, XP055415571, Gefunden im Internet: URL:http://www.gomatlab.de/vergleich-zweie r-kurven-t24025.html [gefunden am 2017-10-13]

## Beschreibung

Die Erfindung betrifft ein Verfahren zur Bestimmung des Alters eines elektrochemischen Energiespeichers, wobei hierzu wenigstens eine Ruhespannungskurve des elektrochemischen Energiespeichers herangezogen wird.

Elektrochemische Energiespeicher, insbesondere solche, die auf Lithium basieren, erfordern für ihren wirtschaftlichen Betrieb eine ausreichend lange Lebensdauer. Hierbei muss sowohl eine hohe kalendarische Lebensdauer als auch eine hohe Zyklenzahl sichergestellt werden.

Zur Bestimmung des Alters oder der Alterung eines elektrochemischen Energiespeichers ist eine Vielzahl von Verfahren aus dem Stand der Technik bekannt. Exemplarisch seien hierzu die Patentanmeldungen WO 2010 084070 A1, EP 2 389 703 A1, DE 10 2013 217752, DE 10 2013 213253 und EP 1 450 173 A2 genannt.

Insbesondere sind Verfahren zur Bestimmung des Alters oder der Alterung eines elektrochemischen Energiespeichers von Vorteil, welche seinen Betrieb möglichst gering beeinflussen, zeitlich begrenzt sind, keine zusätzliche Alterung des elektrochemischen Energiespeichers bewirken sowie messtechnisch eine möglichst geringen Energietransfer des elektrochemischen Energiespeichers erfordern. Weiterhin ist es von Vorteil, wenn ein Verfahren zur Bestimmung des Alters eines elektrochemischen Energiespeichers als ein autonomes Messverfahren realisiert ist, welches beispielsweise über einen Fernzugriff (engl. Remote) durchführbar ist.

Ein Nachteil der oben genannten bekannten Verfahren ist, dass zur Bestimmung des Alters des elektrochemischen Energiespeichers typischerweise ein Abkoppeln des elektrochemischen Energiespeichers von seinem Regelbetrieb erforderlich ist.

Dies ist insbesondere bei einer Impedanzspektroskopie gemäß der Patentanmeldung EP 2 389 703 A1 gegeben. Auch das Verfahren gemäß der Patentanmeldung EP 1 450 173 A2, bei dem das Alter oder die Alterung eines elektrochemischen Energiespeichers mittels voller Lade- und Entladezyklen bestimmt wird, weist diesen Nachteil auf. Weiterhin sind Verfahren, die eine punktuelle Bestimmung des Alters oder der Alterung des elektrochemischen Energiespeichers aufweisen typischerweise fehleranfälliger.

Eine Bestimmung des Alters eines elektrochemischen Energiespeichers ist von großer Bedeutung, insbesondere in Bezug auf die Betriebssicherheit des elektrochemischen Energiespeichers.

Der vorliegenden Erfindung liegt die Aufgabe zugrunde, ein verbessertes Verfahren zur Bestimmung des Alters eines elektrochemischen Energiespeichers bereitzustellen.

Die Aufgabe wird durch ein Verfahren mit den Merkmalen des unabhängigen Patentanspruches 1, durch einen elektrochemischen Energiespeicher mit den Merkmalen des unabhängigen Patentanspruches 3 sowie durch ein Luftfahrzeug mit den Merkmalen des unabhängigen Patentanspruches 5 gelöst. In den abhängigen Patentansprüchen sind vorteilhafte Ausgestaltungen und Weiterbildungen der Erfindung angegeben.

Das erfindungsgemäße Verfahren zur Bestimmung des Alters eines elektrochemischen Energiespeichers umfasst die folgenden Schritte:
- Bereitstellen einer ersten vom Ladezustand des elektrochemischen Energiespeichers abhängigen Ruhespannungskurve des elektrochemischen Energiespeichers als Referenz;
- Ermitteln einer zweiten vom Ladezustand des elektrochemischen Energiespeichers abhängigen Ruhespannungskurve des elektrochemischen Energiespeichers; und
- Bestimmen des Alters des elektrochemischen Energiespeichers mittels eines Vergleiches der ersten und zweiten Ruhespannungskurve.

Erfindungsgemäß wird als Referenz die erste Ruhespannungskurve des elektrochemischen Energiespeichers bereitgestellt. Diese wird besonders bevorzugt für einen neuen, das heißt einen bisher noch nicht betriebenen elektrochemischen Energiespeicher ermittelt. Die dadurch ermittelte erste Ruhespannungskurve kann somit als Referenz für den Vergleich der später ermittelten zweiten Ruhespannungskurve herangezogen werden. Mit anderen Worten liegt der vorliegenden Erfindung die Erkenntnis zugrunde, dass die Ruhespannungskurve des elektrochemischen Energiespeichers von seinem Alter abhängig ist. Durch einen Vergleich der ersten und zweiten Ruhespannungskurven kann erfindungsgemäß eine Bestimmung des Alters des elektrochemischen Energiespeichers erfolgen.

Die erste und zweite Ruhespannungskurve gibt hierbei eine Abhängigkeit der Ruhespannung (engl. Open Circuit Voltage; OCV) des elektrochemischen Energiespeichers von seinem Ladezustand (engl. State of Charge; SOC) an. Diese Abhängigkeit kann mittels eines Diagramms als Kurve dargestellt oder mittels Tabellen, Matrizen oder Vergleichbaren als funktionaler Zusammenhang erfasst, hinterlegt und/oder gespeichert werden. Die Ermittlung der Abhängigkeit der Ruhespannung des elektrochemischen Energiespeichers von seinem Ladezustand entspricht daher dem Ermitteln der ladezustandsabhängigen Ruhespannungskurve.

Vorteilhafterweise wird durch das erfindungsgemäße Verfahren eine Bestimmung des Alters des elektrochemischen Energiespeichers ermöglicht, welches möglichst gering in den Betrieb des elektrochemischen Energiespeichers eingreift. Dadurch verringern sich die Ausfallzeiten des elektrochemischen Energiespeichers. Weiterhin ergibt sich vorteilhafterweise kein zusätzlicher Energieverbrauch.

Ein weiterer Vorteil des erfindungsgemäßen Verfahrens ist, dass das kalendarische Alter des elektrochemischen Energiespeichers und das zyklische Alter des elektrochemischen Energiespeichers aus dem Vergleich der Ruhespannungskurven bestimmt werden können. Weiterhin ermöglicht das erfindungsgemäße Verfahren mittels eines Lernprozesses eine Vorhersage (engl. Forecast) über einen möglichen Verlauf des Alters beziehungsweise der Alterung des elektrochemischen Energiespeichers und seiner Leistung. Dadurch kann vorteilhafterweise ein zukünftiger optimierter Betrieb des elektrochemischen Energiespeichers erfolgen.

Erfindungsgemäß wird als Vergleich eine Fläche zwischen der ersten und der zweiten Ruhespannungskurve herangezogen.

Vorteilhafterweise kann hierdurch das Alter des elektrochemischen Energiespeichers besonders genau bestimmt werden. Das ist deshalb der Fall, da durch die Bestimmung des Alters des elektrochemischen Energiespeichers über die Fläche zwischen der ersten und der zweiten Ruhespannungskurve ein Bereich oder wenigstens eine Mehrzahl von Werten der Ruhespannungskurven berücksichtigt werden, das heißt in die Bestimmung des Alters einfließen. Dadurch stellt die bestimmende Fläche einen bezüglich der Ruhespannungskurven globalen Vergleich der ersten und der zweiten Ruhespannungskurve dar. Typischerweise nimmt die Fläche zwischen der ersten und der zweiten Ruhespannungskurve mit dem Alter des elektrochemischen Energiespeichers zu, sodass aus dieser Zunahme sein Alter bestimmt werden kann.

Erfindungsgemäß wird die Fläche durch ein Integral gebildet, wobei die untere Grenze des Integrals durch einen Schnittpunkt der zwei Ruhespannungskurven und die obere Grenze des Integrals durch wenigstens einen Wert des Ladezustandes festgelegt wird.

Vorteilhafterweise wird dadurch die Bestimmung des Alters des elektrochemischen Energiespeichers weiter verbessert. Insbesondere wird als untere Grenze des Integrals der Schnittpunkt der zwei Ruhespannungskurven herangezogen, sodass sich eine dreiecksartige oder dreiecksförmige geometrische Gestalt der Fläche ergibt. Hierbei korrespondiert der Schnittpunkt zu einem Wert der Ruhespannung und einem Wert des Ladezustandes des elektrochemischen Energiespeichers. Die untere Grenze ist somit wiederum durch einen Wert des Ladezustandes festgelegt, der dem Wert, der dem Schnittpunkt zugehörig ist, entspricht. Mit anderen Worten korrespondiert ein Punkt oder ein Wert einer der Ruhespannungskurven, insbesondere ein Schnittpunkt, stets zu einem Wert der Ruhespannung (Ruhespannungswert) und einem Wert des Ladezustandes (Ladezustandswert).

In einer vorteilhaften Weiterbildung der Erfindung wird das Alter über einen Proportionalitätsfaktor zur Fläche bestimmt.

Mit anderen Worten ist die Fläche umso größer, je älter der elektrochemische Energiespeicher ist. Entspricht die zweite Ruhespannungskurve in etwa der ersten Ruhespannungskurve, die als Referenz herangezogen wird, so ist der Unterschied zwischen den zwei genannten Kurven gering, sodass sich nur eine kleine Fläche zwischen der ersten und der zweiten Ruhespannungskurve ausbildet. Mit anderen Worten ist der elektrochemische Energiespeicher in Bezug auf die erste Ruhespannungskurve nur gering gealtert. Wird zu einem späteren Zeitpunkt die zweite Ruhespannungskurve bestimmt, so vergrößert sich die Fläche zwischen der ersten und der zweiten Ruhespannungskurve, welche Vergrößerung direkt proportional zum Alter des elektrochemischen Energiespeichers ist. Der Proportionalitätsfaktor kann von der Art des elektrochemischen Energiespeichers abhängen und weist die Dimension Zeit pro Fläche auf.

Hierbei ist es besonders bevorzugt, wenn das Alter mittels des zum Schnittpunkt zugehörigen Wertes des Ladezustandes oder mittels des zum Schnittpunkt zugehörigen Wertes der Ruhespannung bestimmt wird.

Dadurch wird die Bestimmung des Alters des elektrochemischen Energiespeichers weiter verbessert.

Gemäß einer vorteilhaften Ausgestaltung der Erfindung wird als Vergleich ein Schnittpunkt der zwei Ruhespannungskurven herangezogen.

Vorteilhafterweise wird dadurch ein alternatives Verfahren zur Bestimmung des Alter des elektrochemischen Energiespeichers bereitgestellt, bei dem eine Änderung des Schnittpunktes der Ruhespannungskurven mit dem Alter des elektrochemischen Energiespeichers zur Bestimmung des Alters herangezogen wird. Dies stellt somit eine im Vergleich zur Fläche (globaler Vergleich) lokalen Vergleich dar.

Hierbei ist es besonders bevorzugt, wenn das Alter mittels des zum Schnittpunkt zugehörigen Wertes des Ladezustandes oder mittels des zum Schnittpunkt zugehörigen Wertes der Ruhespannung bestimmt wird.

Dadurch kann vorteilhafterweise die Bestimmung des Alters des elektrochemischen Energiespeichers weiter verbessert werden.

Gemäß einer vorteilhaften Ausgestaltung der Erfindung wird als Vergleich eine betragsmäßige Differenz zwischen einem Ruhespannungswert der ersten Ruhespannungskurve und einem Ruhespannungswert der zweiten Ruhespannungskurve bei einem festgelegten gemeinsamen Wert des Ladezustandes herangezogen.

Vorteilhafterweise wird dadurch ein differenzielles Verfahren (lokaler Vergleich) zur Bestimmung des Alters des elektrochemischen Energiespeichers bereitgestellt.

Hierbei ist es bevorzugt, wenn der gemeinsame Wert des Ladezustandes im Bereich von 80 Prozent bis 95 Prozent, besonders bevorzugt im Bereich von 85 Prozent bis 90 Prozent, festgelegt wird.

Der erfindungsgemäße elektrochemische Energiespeicher umfasst eine Messvorrichtung sowie eine Rechenvorrichtung. Erfindungsgemäß ist die Rechenvorrichtung zur Speicherung einer ersten Ruhespannungskurve und die Messvorrichtung zur Erfassung einer zweiten Ruhespannungskurve ausgebildet. Hierbei ist die Rechenvorrichtung erfindungsgemäß dazu ausgebildet, das Alter des elektrochemischen Energiespeichers mittels eines Verfahrens gemäß der vorliegenden Erfindung zu bestimmen.

Es ergeben sich zum bereits genannten erfindungsgemäßen Verfahren gleichartige und gleichwertige Vorteile des erfindungsgemäßen elektrochemischen Energiespeichers.

Besonders bevorzugt ist der elektrochemische Energiespeicher als eine Lithium-Ionen-Batterie, eine Blei-Batterie, eine Nickel-Batterie, eine Redox-Fluss-Batterie oder ein Kondensator ausgebildet.

Vorteilhafterweise können dadurch technisch ausgereifte und fortschrittliche elektrochemische Energiespeicher verwendet werden. Weiterhin wird dadurch die Möglichkeit der Integration oder Anwendung der vorliegenden Erfindung auf bekannte elektrochemische Energiespeicher erweitert und verbessert.

Die vorliegende Erfindung kann für Batteriesysteme, Batteriemodule und/oder Zusammenschaltungen von Batterien (seriell oder parallel) vorgesehen sein.

Das erfindungsgemäße Luftfahrzeug, insbesondere elektrisches Flugzeug oder elektrisches Passagierflugzeug ist dadurch gekennzeichnet, dass dieses einen elektrochemischen Energiespeicher gemäß der vorliegenden Erfindung umfasst.

Mit anderen Worten weist das erfindungsgemäße Luftfahrzeug einen erfindungsgemäßen elektrochemischen Energiespeicher auf. Das ist deshalb von Vorteil, da dadurch die Betriebssicherheit des Luftfahrzeuges, die entscheidend für dessen Betrieb ist, erhöht, weiter verbessert und/oder sichergestellt wird.

Als Luftfahrzeug ist insbesondere ein elektrisches Flugzeug oder ein elektrisches Passagierflugzeug, ein elektrischer Hubschrauber oder eine elektrische Drohne vorgesehen. Hierbei ist es besonders bevorzugt den erfindungsgemäßen elektrochemischen Energiespeicher zum Vortrieb des Luftfahrzeuges zu verwenden.

Mit anderen Worten ist gemäß einer vorteilhaften Weiterbildung des erfindungsgemäßen Luftfahrzeuges der elektrochemische Energiespeicher zum Vortrieb des Luftfahrzeuges ausgebildet.

Hierbei wird der elektrochemische Energiespeicher hauptsächlich zum Antrieb des Luftfahrzeuges verwendet, wobei dieser wenigstens zu 50 Prozent, das heißt hauptsächlich, die elektrische Energie für den Vortrieb des Luftfahrzeuges bereitstellt. Weiterhin ergeben sich zum erfindungsgemäßen elektrochemischen Energiespeicher gleichartige und gleichwertige Vorteile des erfindungsgemäßen Luftfahrzeuges.

Vorteilhafterweise kann dadurch die Betriebssicherheit des Luftfahrzeuges erhöht werden.

Weitere Vorteile, Merkmale und Einzelheiten der Erfindung ergeben sich aus dem im Folgenden beschriebenen Ausführungsbeispiel sowie anhand der Zeichnungen. Dabei zeigen schematisiert:
- Figur 1: ein erstes Diagramm zur Bestimmung des Alters eines elektrochemischen Energiespeichers; und
- Figur 2: ein zweites Diagramm zur Bestimmung des Alters eines elektrochemischen Energiespeichers.

Gleichartige, gleichwertige oder gleichwirkende Elemente können in den Figuren mit denselben Bezugszeichen versehen sein.

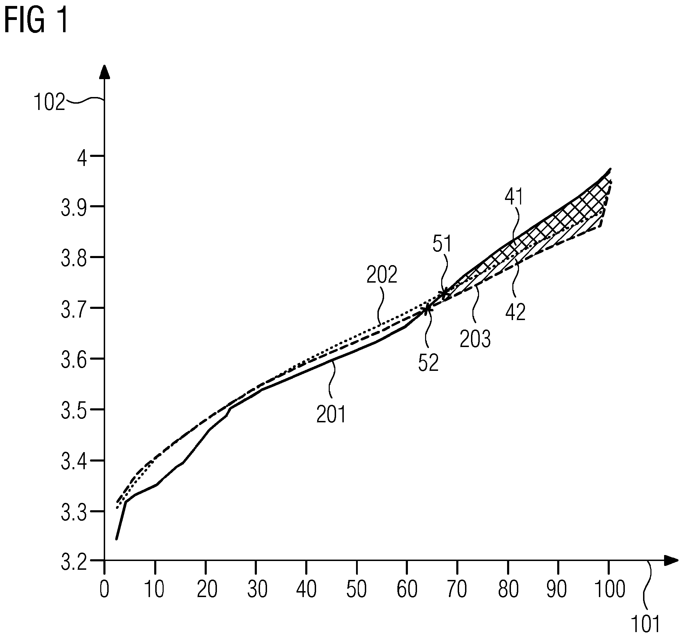

Figur 1 zeigt das erste Diagramm, das zur Bestimmung des Alters des elektrochemischen Energiespeichers herangezogen wird. Hierbei ist an der Abszisse 101 des Diagramms der Ladezustand des elektrochemischen Energiespeichers in Prozent aufgetragen. Der elektrochemische Energiespeicher ist bei 0 Prozent vollständig entladen und bei 100 Prozent vollständig geladen. An der Ordinate 102 des Diagramms ist die Ruhespannung des elektrochemischen Energiespeichers in Volt aufgetragen. Weiterhin ist hierbei der elektrochemische Energiespeicher exemplarisch als Lithium-Ionen-Batterie ausgebildet.

Das Diagramm in Figur 1 zeigt eine erste Ruhespannungskurve 201, eine zweite Ruhespannungskurve 202 sowie eine dritte Ruhespannungskurve 203. Hierbei wurde die erste Ruhespannungskurve 201 zeitlich zuerst für einen neuen elektrochemischen Energiespeicher ermittelt oder bereitgestellt. Die zweite Ruhespannungskurve 202 wurde zu einem späteren Zeitpunkt als die erste Ruhespannungskurve 201 für den gleichen elektrochemischen Energiespeicher ermittelt. Die dritte Ruhespannungskurve 203 wurde bezüglich der zweiten Ruhespannungskurve 202 zu einem späteren Zeitpunkt für den gleichen elektrochemischen Energiespeicher ermittelt. Deutlich ist eine Veränderung der Ruhespannungskurven 201, 202, 203 über die Zeit zu erkennen.

Die zweite Ruhespannungskurve 202 und die dritte Ruhespannungskurve 203 weisen jeweils einen Schnittpunkt 51, 52 mit der ersten Ruhespannungskurve 201 auf. Dadurch ist zwischen der ersten Ruhespannungskurve 201 und der zweiten Ruhespannungskurve 202 eine erste Fläche 41 eingeschlossen sowie zwischen der ersten Ruhespannungskurve 201 und der dritten Ruhespannungskurve 203 eine zweite Fläche 42 eingeschlossen. Erfindungsgemäß wird die Größe oder das Maß der ersten Fläche 41 beziehungsweise die Größe der zweiten Fläche 42 zur Bestimmung des Alters des elektrochemischen Energiespeichers herangezogen. Hierbei ist die erste Fläche 41 zwischen der ersten Ruhespannungskurve 201 und der zweiten Ruhespannungskurve 202 sowie die zweite Fläche 42 zwischen der ersten Ruhespannungskurve 201 und der dritten Ruhespannungskurve 203 umso größer, je älter der elektrochemische Energiespeicher ist. Mit anderen Worten ist die zweite Fläche 42 größer als die erste Fläche 41. Aus der Größe der Flächen 41, 42 wird das Alter des elektrochemischen Energiespeichers, beispielsweise über einen Proportionalitätsfaktor, bestimmt. Die Größe der Fläche 41, 42 kann durch ein Integral oder numerisch durch eine Summe, insbesondere eine Riemannsche Summe, bestimmt werden. Als untere Grenze des Integrals wird jeweils der Schnittpunkt 51, 52 beziehungsweise dessen zugeordneter Ladezustandswert herangezogen. Als obere Grenze des Integrals kann ein gemeinsamer Wert des Ladezustandes festgelegt werden, beispielsweise ein Ladezustand von 100 Prozent.

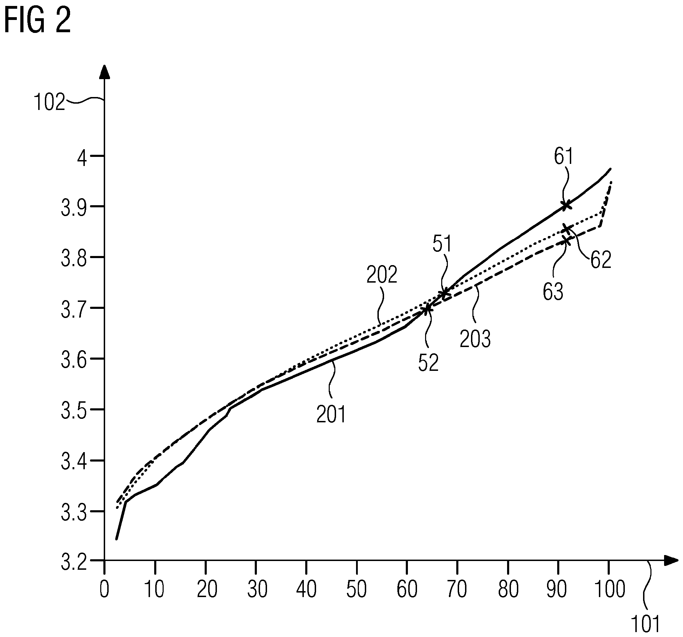

Figur 2 zeigt das zweite Diagramm, das zur Bestimmung des Alters eines elektrochemischen Energiespeichers herangezogen werden kann. Wie bereits in Figur 1 ist in Figur 2 an der Abszisse 101 der Ladezustand des elektrochemischen Energiespeichers in Prozent aufgetragen. Die Ordinate des Diagramms 102 zeigt die Ruhespannung des elektrochemischen Energiespeichers in Volt an. Wiederum wurde eine Lithium-Ionen-Batterie verwendet.

Wie bereits in Figur 1 umfasst das in Figur 2 dargestellte Diagramm drei Ruhespannungskurven 201, 202, 203. Hierbei ist jeder Punkt der Ruhespannungskurven 201, 202, 203 durch einen Ruhespannungswert und einen dem Ruhespannungswert zugehörigen Ladezustandswert des elektrochemischen Energiespeichers gekennzeichnet. Mit anderen Worten ist ein Punkt einer der Ruhespannungskurven 201, 202, 203, insbesondere ein Schnittpunkt, durch zwei Werte festgelegt, das heißt durch einen Wert der Ruhespannung und einen Wert des Ladezustandes des elektrochemischen Energiespeichers.

Zur Bestimmung des Alters des elektrochemischen Energiespeichers kann ein erster Schnittpunkt 51 zwischen der ersten Ruhespannungskurve 201 und der zweiten Ruhespannungskurve 202 herangezogen werden. Sind die erste Ruhespannungskurve 201 und die zweite Ruhespannungskurve 202 deckungsgleich, so ergibt sich kein Schnittpunkt, sodass der elektrochemische Energiespeicher somit nicht gealtert ist. Durch die Alterung des elektrochemischen Energiespeichers bildet sich der erste Schnittpunkt 51 oder der zweite Schnittpunkt 52 aus, wobei jedem Schnittpunkt 51, 52 ein Wert der Ruhespannung sowie ein Wert des Ladezustandes zugeordnet ist. Aus den genannten Werten der Ruhespannung und des Ladezustandes kann die Alterung des elektrochemischen Energiespeichers bestimmt werden. Hierbei nimmt der dem ersten Schnittpunkt 51 zugeordnete Wert des Ladezustandes sowie der dem ersten Schnittpunkt 51 zugeordnete Wert der Ruhespannung mit dem Alter des elektrochemischen Energiespeichers ab. Dies ist deutlich aus der Position des zweiten Schnittpunktes 52 zwischen der ersten Ruhespannungskurve 201 und der dritten Ruhespannungskurve 203 in Bezug auf die Position des ersten Schnittpunktes 51 zu erkennen. Hierbei wurde die dritte Ruhespannungskurve 203 zu einem späteren Zeitpunkt als die zweite Ruhespannungskurve 202 ermittelt.

Ein weiteres erfindungsgemäßes Verfahren zur Bestimmung des Alters des elektrochemischen Energiespeichers kann durch eine Differenz von Werten der den Ruhespannungskurven 201, 202, 203 zugeordnete Werte der Ruhespannung bereitgestellt werden. Hierbei wird ein gemeinsamer Ladezustandswert beziehungsweise Wert des Ladezustandes des elektrochemischen Energiespeichers festgelegt. In dem dargestellten Diagramm wird der gemeinsame Wert des Ladezustandes bei etwa 92 Prozent festgelegt. Zu diesem Wert des Ladezustandes korrespondiert jeweils ein zugehöriger Wert der Ruhespannung der sich aus der Ordinate des dargestellten Diagramms ergibt. Dadurch ergeben sich die Punkte 61, 62, 63 auf den entsprechenden Ruhespannungskurven 201, 202, 203. Aus der betragsmäßigen Differenz der den Punkten 61, 62, 63 zugeordneten Werten der Ruhespannung kann das Alter des elektrochemischen Energiespeichers bestimmt werden.

Beispielsweise wird der dem Punkt 62 zugeordnete Wert der Ruhespannung von dem dem Punkt 61 zugeordneten Wert der Ruhespannung abgezogen. Aus dieser numerischen Differenz, welche Proportional zum Alter des elektrochemischen Energiespeichers ist, kann das Alter des elektrochemischen Energiespeichers bestimmt werden. Für den Punkt 63 wird analog verfahren, das heißt der dem Punkt 63 zugeordnete Wert der Ruhespannung wird von dem Wert der Ruhespannung des Punktes 61 abgezogen, wobei wiederum der Betrag dieser Differenz proportional zum Alter des elektrochemischen Energiespeichers ist. Als Referenz wird somit der Punkt 61 auf der ersten Ruhespannungskurve 201 herangezogen.

Die Ermittlung der Ruhespannungskurven 201, 202, 203 kann mittels einer Stromzählrate kleiner 0,1 durch Berechnung einer Ruhespannungskurve aus dem Mittelwert von Lade- und Entladekurven bei gleichen Lade- und Entladeraten oder Ruhespannungswert nach Wartezeit beziehungsweise Reaktionszeit der Spannung bei einer Strombelastung von I=0 erfolgen. Die Werte der Ruhespannung der jeweiligen Ruhespannungskurven 201, 202, 203 werden dem jeweiligen Wert des Ladezustandes des elektrochemischen Energiespeichers zugeordnet, sodass sich die in Figur 1 beziehungsweise in Figur 2 dargestellten Diagramme ergeben.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann jeweils abgeleitet werden, ohne den Schutzumfang der Erfindung zu verlassen, welcher durch die Ansprüche bestimmt wird. .

## Patentansprüche

1. Verfahren zur Bestimmung des Alters eines elektrochemischen Energiespeichers, umfassend die Schritte:
- Bereitstellen einer ersten vom Ladezustand des elektrochemischen Energiespeichers abhängigen Ruhespannungskurve (201) des elektrochemischen Energiespeichers als Referenz;
- Ermitteln einer zweiten vom Ladezustand des elektrochemischen Energiespeichers abhängigen Ruhespannungskurve (202) des elektrochemischen Energiespeichers; und
- Bestimmen des Alters des elektrochemischen Energiespeichers mittels eines Vergleiches der ersten und zweiten Ruhespannungskurve (201, 202), **dadurch gekennzeichnet, dass** als Vergleich eine Fläche (41)
zwischen der ersten und der zweiten Ruhespannungskurve (201, 202) herangezogen wird; und die Fläche (41) durch ein Integral gebildet wird, wobei die untere Grenze des Integrals durch einen Schnittpunkt (51) der zwei Ruhespannungskurven (201, 202) und die obere Grenze des Integrals durch wenigstens einen Wert des Ladezustandes festgelegt wird.

2. Verfahren gemäß Anspruch 1, bei dem das Alter über einen Proportionalitätsfaktor zur Fläche (41) bestimmt wird.

3. Elektrochemischer Energiespeicher, umfassend eine Messvorrichtung und eine Rechenvorrichtung, wobei die Rechenvorrichtung zur Speicherung einer ersten Ruhespannungskurve (201) und die Messvorrichtung zur Erfassung einer zweiten Ruhespannungskurve (202) ausgebildet ist, wobei die Rechenvorrichtung weiterhin dazu ausgebildet ist, das Alter des elektrochemischen Energiespeichers mittels eines Verfahrens gemäß einem der vorhergehenden Ansprüche zu bestimmen.

4. Elektrochemischer Energiespeicher gemäß Anspruch 3, **dadurch gekennzeichnet, dass** dieser als eine Lithium-Ionen-Batterie, eine Blei-Batterie, eine Nickel-Batterie, eine Redox-Fluss-Batterie oder ein Kondensator ausgebildet ist.

5. Luftfahrzeug, insbesondere elektrisches Flugzeug oder elektrisches Passagierflugzeug, **dadurch gekennzeichnet, dass** dieses einen elektrochemischen Energiespeicher gemäß einem der Ansprüche 3 bis 4 umfasst.

6. Luftfahrzeug gemäß Anspruch 5, **dadurch gekennzeichnet, dass** der elektrochemische Energiespeicher zum Vortrieb des Luftfahrzeuges ausgebildet ist.

## Claims

1. Method for determining the age of an electrochemical energy storage unit, comprising the following steps:
- providing a first quiescent voltage curve (201) of the electrochemical energy storage unit, which is dependent on the state of charge of the electrochemical energy storage unit, as a reference;
- ascertaining a second quiescent voltage curve (202) of the electrochemical energy storage unit, which is dependent on the state of charge of the electrochemical energy storage unit; and
- determining the age of the electrochemical energy storage unit by comparing the first and second quiescent voltage curves (201, 202), **characterized in that** an area (41) between the first and second quiescent voltage curves (201, 202) is used as comparison; and the area (41) is formed by an integral, wherein the lower limit of the integral is determined by an intersection point (51) of the two quiescent voltage curves (201, 202) and the upper limit of the integral is determined by at least one value for the state of charge.

2. Method according to Claim 1, wherein the age is determined by means of a proportionality factor with respect to the area (41).

3. Electrochemical energy storage unit comprising a measuring device and a computing device, wherein the computing device is designed to store a first quiescent voltage curve (201) and the measuring device is designed to record a second quiescent voltage curve (202), wherein the computing device is furthermore designed to determine the age of the electrochemical energy storage unit by means of a method according to one of the preceding claims.

4. Electrochemical energy storage unit according to Claim 3, **characterized in that** the electrochemical energy storage unit is designed as a lithium-ion battery, a lead-acid battery, a nickel battery, a redox flow battery, or a capacitor.

5. Aircraft, in particular electrically powered aircraft or electrically powered passenger aircraft, **characterized in that** the aircraft comprises an electrochemical energy storage unit according to one of Claims 3 to 4.

6. Aircraft according to Claim 5, **characterized in that** the electrochemical energy storage unit is designed for the propulsion of the aircraft.

## Revendications

1. Procédé de détermination de l'âge d'un accumulateur d'énergie électrochimique, ledit procédé comprenant les étapes suivantes :
- fournir une première courbe de tension de repos (201) de l'accumulateur d'énergie électrochimique comme référence, laquelle première courbe dépend de l'état de charge de l'accumulateur d'énergie électrochimique ;
- déterminer une deuxième courbe de tension de repos (202) de l'accumulateur d'énergie électrochimique, laquelle deuxième courbe dépend de l'état de charge de l'accumulateur d'énergie électrochimique ; et
- déterminer l'âge de l'accumulateur d'énergie électrochimique par comparaison des première et deuxième courbes de tension de repos (201, 202), **caractérisé en ce que**
une surface (41) formée entre la première et la deuxième courbe de tension de repos (201, 202) est utilisée comme comparaison ; et la surface (41) est formée par une intégrale, la borne inférieure de l'intégrale étant définie par un point d'intersection (51) des deux courbes de tension de repos (201, 202) et la borne supérieure de l'intégrale étant définie par au moins une valeur de l'état de charge.

2. Procédé selon la revendication 1, dans lequel l'âge est déterminé par un facteur de proportionnalité par rapport à la surface (41).

3. Accumulateur d'énergie électrochimique, comprenant un dispositif de mesure et un dispositif informatique, le dispositif informatique étant conçu pour mémoriser une première courbe de tension de repos (201) et le dispositif de mesure étant conçu pour acquérir une deuxième courbe de tension de repos (202), le dispositif informatique étant en outre conçu pour déterminer l'âge de l'accumulateur d'énergie électrochimique au moyen d'un procédé selon l'une des revendications précédentes.

4. Accumulateur d'énergie électrochimique selon la revendication 3, **caractérisé en ce qu'**il est conçu sous la forme d'une batterie à ion lithium, d'une batterie au plomb, d'une batterie au nickel, d'une batterie à flux redox ou d'un condensateur.

5. Aéronef, notamment aéronef électrique ou aéronef électrique de transport de passagers, **caractérisé en ce qu'**il comprend un accumulateur d'énergie électrochimique selon l'une des revendications 3 à 4.

6. Aéronef selon la revendication 5, **caractérisé en ce que** l'accumulateur d'énergie électrochimique est destiné à propulser l'aéronef.
